# EUROPEAN PATENT APPLICATION

(11) **EP 2 209 030 A1**
(43) Date of publication of application: **21.07.2010**
(21) Application number: 09731618.6
(22) Date of filing: 20.02.2009
(51) Int. Cl.: G02B 6/42, G02B 6/122, H01S 5/022

(54) **OPTICAL MODULE AND PHOTOELECTRIC CONVERTER**

(30) Priority: 16.04.2008 JP 2008106520
(71) Applicant: Japan Aviation Electronics Industry, Limited, Tokyo 150-0043 (JP)
(72) Inventor: SHIRATORI, Masayuki, Tokyo 1500043 (JP); AIHARA, Shuichi, Tokyo 1500043 (JP)
(74) Representative: MERH-IP Matias Erny Reichl Hoffmann
(86) International application number: PCT/JP2009/052995
(87) International publication number: WO 2009/128290

(57) **Abstract**

An object of the present invention is to provide an optical module with a small width at low cost. The optical module of the present invention includes an optical waveguide substrate, a light emitting element, a light receiving element, a light emitting element IC, a light receiving element IC, and a plug body. The optical waveguide substrate has a light input/output face and two inclined reflecting surfaces disposed at different distances from the light input/output face. The light emitting element is disposed at a position corresponding to one of the inclined reflecting surfaces on the optical waveguide substrate. The light receiving element is disposed at a position corresponding to the other inclined reflecting surface on the optical waveguide substrate. The light emitting element IC controls the light emitting element. The light receiving element IC controls the light receiving element. The plug body is formed by a plurality of insulator layers and has, on the different insulator layers, a wiring pattern for the light emitting element between the light emitting element and the light emitting element IC and a wiring pattern for the light receiving element between the light receiving element and the light receiving element IC.

## Description

### TECHNICAL FIELD

The present invention relates to an optical module and a photoelectric converter for conversion between an electric signal and an optical signal and the transmission and reception of the optical signal.

### BACKGROUND ART

Optical modules having optical waveguides and electric wiring are disclosed in the examples of patent literature 1 and patent literature 2. In these optical modules, methods are proposed for converting an electric signal and an optical signal and transmitting and receiving the optical signal with a single module.
Patent literature 1: Japanese Patent Application Laid-Open No. 2006-91241
Patent literature 2: Japanese Patent Application Laid-Open No. 2000-214351

### DISCLOSURE OF THE INVENTION

### PROBLEM TO BE SOLVED BY THE INVENTION

An object of the optical module in patent literature 1 is to provide a photoelectric composite wiring component which can achieve high-speed, high-capacity, and high-quality transmission of information with high noise immunity. However, the optical module has problems in size reduction and improvements of high frequency characteristics.

As described in patent literature 2, in the optical module for guiding the light of an optical waveguide to a light receiving element or guiding the light of a light emitting element to the optical waveguide by using the inclined surface of the optical waveguide, the inclined surface is disposed on an end of the optical waveguide. Thus the light receiving element and the light emitting element are generally arranged side by side. Thus, since the light emitting element and the light receiving element are disposed close to each other with a large difference in signal level, it has been a challenge to suppress electromagnetic crosstalk and optical crosstalk (caused by stray light) in this part. Hence, in the prior art, a light emitting element and a light receiving element have to be sufficiently separated from each other in some way or a shield has to be provided between the elements. These measures increase the width of an optical module (a width perpendicular to the direction of travel of light) and cause a complicated structure, thereby interfering the size and cost reduction of the optical module.

In a folding cellular phone and the like, it is necessary to pass a signal wire through a hinge. Particularly, for the hinges of recent folding cellular phones, a biaxial rotation is often required instead of a uniaxial rotation. In a biaxial hinge, a first shaft is a shaft for opening and closing a folding cellular phone and a second shaft is a shaft disposed perpendicularly to the first shaft. In the case of the hinge of a folding cellular phone, a space allowing the passage of a signal wire in the hinge is a circular hole having a diameter of about 3 mm. In the prior art, a plurality of thin coaxial cables are drawn into the space. However, the higher the functionality of cellular phones, an amount of signal passing through a hinge part increases and the wiring of coaxial cables reaches the limit. In some methods, an optical fiber is used as a signal line instead of a plurality of coaxial cables. The optical module of the prior art is, however, too large in size to pass through a hole having a diameter of 3 mm. Thus, when using the optical module of the prior art, it is necessary to connect an optical fiber and the optical module during the assembly of an end product. However, the assembly of optical components and the assembly of an end product generally require different operator skills or optical components and an end product are manufactured by different manufacturers. Thus, the optical module which is too large in size to pass through a hole having a diameter of 3 mm has interfered with the use of an optical fiber as a signal wire instead of a plurality of coaxial cables.

The present invention has been devised in view of the foregoing problems. An object of the present invention is to provide an optical module with a small width (a width perpendicular to the direction of travel of light) at low cost, particularly, an optical module which can pass through a hole having a diameter of 3 mm.

### MEANS TO SOLVE THE PROBLEMS

An optical module of the present invention includes an optical waveguide substrate, a light emitting element, a light receiving element, a light emitting element IC, a light receiving element IC, and a plug body. The optical waveguide substrate has two optical waveguides arranged in parallel, a light input/output face formed on one end of each the optical waveguides, and two inclined reflecting surfaces formed for each of the optical waveguide and at a predetermined distance from each other. In other words, the two inclined reflecting surfaces are disposed at different distances from the light input/output face. Further, "parallel" in the above explanation is not limited to a strictly parallel arrangement. The meaning of "parallel" in the above explanation includes a permissible range of design in a range where the optical module can be reduced in width (in a range where the effects of the present invention are obtained). The light emitting element is disposed on the optical waveguide substrate at a position corresponding to one of the inclined reflecting surfaces. The light receiving element is disposed on the optical waveguide substrate at a position corresponding to the other inclined reflecting surface. The light emitting element IC controls the light emitting element. The light receiving element IC controls the light receiving element. The plug body is formed by a plurality of insulator layers and has, on the different insulator layers, a wiring pattern for the light emitting element between the light emitting element and the light emitting element IC and a wiring pattern for the light receiving element between the light receiving element and the light receiving element IC. The optical waveguide substrate is formed on the plug body, and the light emitting element and the wiring pattern for the light emitting element are electrically connected to each other and the light receiving element and the wiring pattern for the light receiving element are electrically connected to each other via bonding wires and the like. It is more preferable that the wiring pattern for the light receiving element is not longer than the wiring pattern for the light emitting element.

### EFFECTS OF THE INVENTION

According to the optical module of the present invention, an optical waveguide substrate has two inclined reflecting surfaces disposed at different distances from a light input/output face, so that a light emitting element and a light receiving element can be separated from each other without increasing the width. Thus it is possible to suppress optical crosstalk (caused by stray light). Moreover, between a wiring pattern for the light emitting element and a wiring pattern for the light receiving element, a distance can be obtained also by forming the wiring patterns on different layers of the insulator layers. Thus it is also possible to suppress electromagnetic crosstalk. Furthermore, since additional structure such as a shield is not necessary, the width can be reduced (a width perpendicular to the direction of travel of light) at low cost. Additionally, in an arrangement where the wiring pattern for the light receiving element is not longer than the wiring pattern for the light emitting element, it is possible to further suppress crosstalk to a received signal at a low signal level, thereby improving high frequency characteristics. Further, with the configuration of the optical module according to the present invention, it is also possible to achieve an optical module which can pass through a hole having a diameter of 3 mm.

### BRIEF DESCRIPTION OF THE DRAWINGS

Fig. 1 is an upper perspective view showing a structural example of a photoelectric converter using an optical module according to a first embodiment;
Fig. 2 is a lower perspective view showing the structural example of the photoelectric converter using the optical module according to the first embodiment;
Fig. 3 is a perspective view showing a structural example of the optical module according to the first embodiment;
Fig. 4A is a plan view showing the structural example of the optical module except for a plug cover according to the first embodiment;
Fig. 4B is a sectional view showing the structural example of the optical module except for the plug cover according to the first embodiment;
Fig. 5 is a sectional view showing a structural example of an optical module except for a plug cover according to a modification of the first embodiment; and
Fig. 6 is a plan view showing a structural example of an optical module except for a plug cover according to a second embodiment.

### DESCRIPTION OF REFERENCE NUMERALS

- 10: photoelectric converter
- 100, 100', 500,: 700 optical module
- 101 plug: cover
- 102, 702: plug body
- 102-1 to 102-4: insulator layer
- 103, 703: optical waveguide substrate
- 104, 704: light emitting element
- 105, 705: light receiving element
- 106, 706: light receiving element IC
- 107, 707: light emitting element IC
- 108, 154, 708: bonding wire for the light emitting element
- 109, 709: bonding wire for the light receiving element
- 110, 711: bonding pad for the light emitting element
- 111, 152, 710: bonding pad for the light emitting element IC
- 112, 712: bonding pad for the light receiving element
- 113, 713: bonding pad for the light receiving element IC
- 120, 721: wiring pattern for the light receiving element
- 121, 153, 720: wiring pattern for the light emitting element
- 122: ground pattern
- 123, 125: cavity
- 124, 126: inclined reflecting surface
- 131,132,731,732: core
- 133, 733: light input/output face
- 134, 734: notch
- 136, 137: terminal
- 141, 142: clad
- 151: insulator part
- 160, 560: electric contact
- 200: receptacle
- 201: receptacle body
- 202: contact
- 203: terminal
- 300: locking cover
- 301 to 305: receptacle holding part
- 306: cut
- 310: cover part
- 400: optical waveguide
- 401, 402: core

### BEST MODES FOR CARRYING OUT THE INVENTION

The following will describe embodiments of the present invention.

### [First Embodiment]

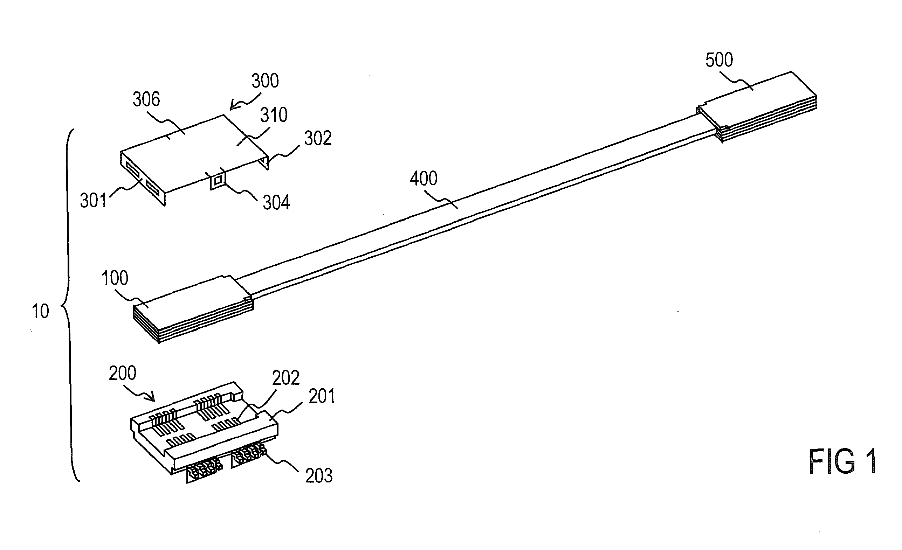

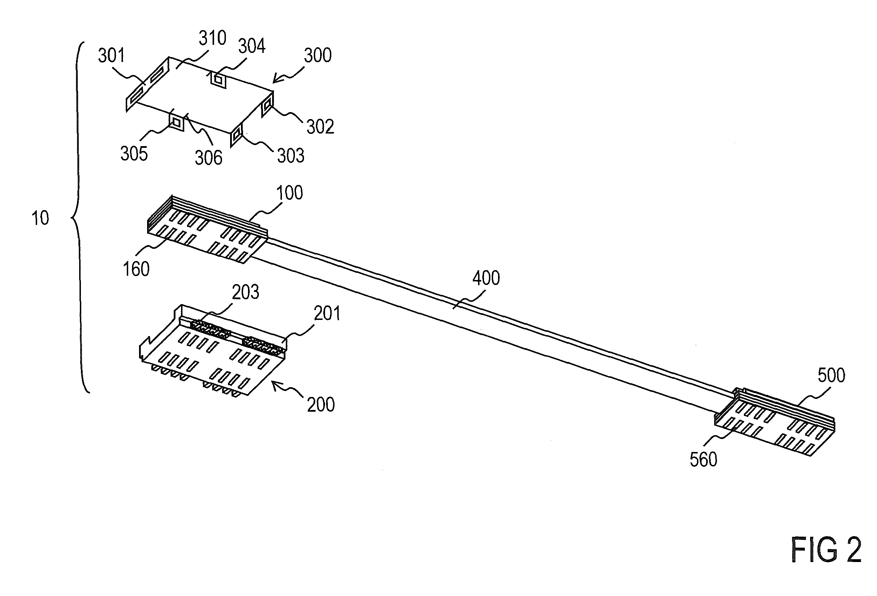

Fig. 1 is an upper perspective view showing a structural example of a photoelectric converter using an optical module according to a first embodiment. Fig. 2 is a lower perspective view showing the structural example of the photoelectric converter using the optical module according to the first embodiment. A photoelectric converter 10 is made up of an optical module 100, a receptacle 200, and a locking cover 300. The optical module 100 is connected via an optical waveguide 400 to an optical module 500 opposed to the optical module 100. The optical modules 100 and 500 respectively have a plurality of electric contacts 160 and 560 (16 contacts in Fig. 2). In the example of Figs. 1 and 2, the electric contacts 160 and 560 are provided on the undersides of the optical modules 100 and 500. It is not necessary to limit the positions of the electric contacts 160 and 560 to the illustrated positions.

The receptacle 200 includes a receptacle body 201 for positioning the optical module 100 and a plurality of terminals 203 (16 terminals in Figs. 1 and 2) which are electrically connected to a plurality of contacts 202 (16 contacts in Figs. 1 and 2) making electrical contact with the electric contacts 160 and are electrically connected to a circuit board and the like.

The locking cover 300 is a cover for fixing the optical module 100 in a state in which the optical module 100 is positioned in the receptacle 200. The locking cover 300 includes a cover part 310 and receptacle holding parts 301 to 305. In the example of Figs. 1 and 2, the cover part 310 has four cuts 306 to increase the moving ranges of the receptacle holding parts 304 and 305. A positioning method and a fixing method of the optical module 100 are not limited to the method of Figs. 1 and 2 and may be designed as appropriate.

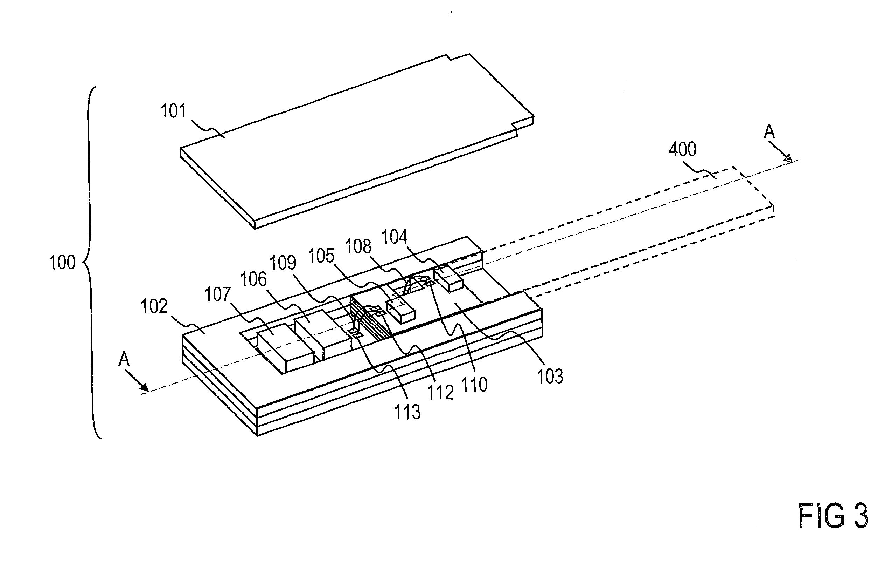

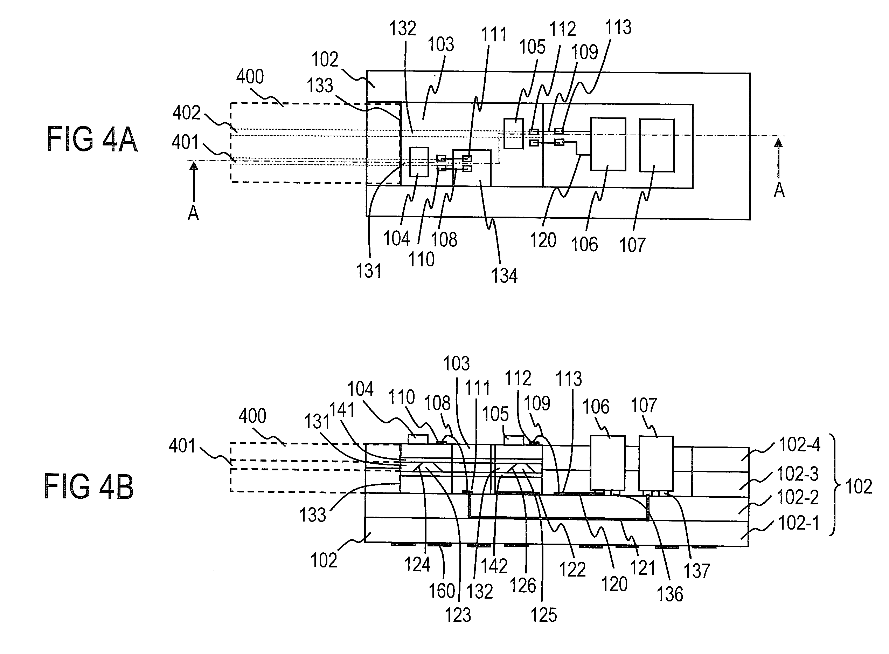

Fig. 3 is a perspective view showing a structural example of the optical module 100. Figs. 4A and 4B are views showing the structural example of the optical module 100 except for a plug cover 101. Fig. 4A is a plan view and Fig. 4B is a sectional view taken along line A-A. The optical module 100 includes an optical waveguide substrate 103, a light emitting element 104, a light receiving element 105, a light emitting element IC 107, a light receiving element IC 106, a plug body 102, and the plug cover 101. The plug cover 101 is a cover for covering the inside of the plug body 102. The optical waveguide substrate 103 has two optical waveguides 131 and 132 arranged in parallel, a light input/output face 133 formed on one end of each the optical waveguides 131 and 132, and two inclined reflecting surfaces 124 and 126. The two inclined reflecting surfaces 124 and 126 are formed for each of the optical waveguide 131 and 132 and at a predetermined distance from each other. In other words, the two inclined reflecting surfaces 124 and 126 are disposed at different distances from the light input/output face 133. Further, "parallel" in the above explanation is not limited to a strictly parallel arrangement. The meaning of "parallel" in the above explanation includes a permissible range of design in a range where the optical module can be reduced in width (in a range where the effects of the present invention are obtained). The light emitting element 104 is disposed on the optical waveguide substrate 103 at a position corresponding to the inclined reflecting surface 124. The light receiving element 105 is disposed on the optical waveguide substrate 103 at a position corresponding to the inclined reflecting surface 126. The light emitting element 104 and the light receiving element 105 are optically coupled to the optical waveguide substrate 103 through the inclined reflecting surfaces 124 and 126.

The light emitting element IC 107 has a plurality of input/output terminals 137 and controls the light emitting element 104. The light receiving element IC 106 has a plurality of input/output terminals 136 and controls the light receiving element 105. The plug body 102 is formed by a plurality of insulator layers 102-1 to 102-4 and has, on the different insulator layers, a wiring pattern 121 for the light emitting element between the light emitting element and the light emitting element IC and a wiring pattern 120 for the light receiving element between the light receiving element and the light receiving element IC. The insulator layers 102-1 to 102-4 are preferably made of ceramic. In the example of Fig. 4B, the wiring pattern 121 for the light emitting element is formed on the insulator layer 102-1 and the wiring pattern 120 for the light receiving element is formed on the insulator layer 102-2. Further, a ground pattern 122 is formed on the insulator layer 102-2. The optical waveguide substrate 103 is disposed on the plug body 102, and the light emitting element 104 and the wiring pattern 121 for the light emitting element are electrically connected to each other and the light receiving element 105 and the wiring pattern 120 for the light receiving element are electrically connected to each other via bonding wires and the like as described below.

The insulator layers 102-3 and 102-4 of the plug body 102 are U-shaped. The optical waveguide substrate 103, the light emitting element IC 107, and the light receiving element IC 106 are disposed in a part surrounded by the insulator layers 102-3 and 102-4 on the insulator layer 102-2. On the back side of the plug body 102, a plurality of electric contacts 160 are formed and are respectively connected to some of the terminals 137 of the light emitting element IC 107 and some of the terminals 136 of the light receiving element IC 106 via wires that are not shown. Thus the terminals 137 of the light emitting element IC 107 and the terminals 136 of the light receiving element IC 106 are electrically connected to the terminals 203 of the receptacle 200, so that power can be fed from a circuit board and the like and an electric signal can be sent and received.

The optical waveguide substrate 103 is opposed to the optical waveguide 400 on the light input/output face 133. A core 401 of the optical waveguide 400 and the core 131 of the optical waveguide substrate 103 are optically connected to each other. Further, a core 402 of the optical waveguide 400 and the core 132 of the optical waveguide substrate 103 are optically connected to each other. A clad 141 is formed around the core 131 and a cavity 123 is formed on a part of the core 131, so that the inclined reflecting surface 124 is formed. A clad 142 is formed around the core 132 and a cavity 125 is formed on a part of the core 132, so that the inclined reflecting surface 126 is formed. The cavities 123 and 125 may be formed by a method such as laser beam machining. For example, the inclined reflecting surfaces 124 and 126 may be formed such that light passing through the optical waveguides 131 and 132 has an angle of incidence of 45°C. The inclined reflecting surfaces 124 and 126 are boundary surfaces between the waveguides and air and thus light passing through the optical waveguides 131 and 132 is totally reflected. Further, on the optical waveguide substrate 103, a notch 134 for wiring is formed. The notch may be a hole.

In the example of Figs. 3 and 4, two wires (not shown) drawn from the light emitting elements 104 are connected to two bonding pads 110 for the light emitting element. The two bonding pads 110 for the light emitting element are respectively connected to two bonding pads 111 for the light emitting element IC via two bonding pads 108 for the light emitting element. The two bonding pads 111 for the light emitting element IC are connected to any of the terminals 137 of the light emitting element IC 107 via the wiring pattern 121 for the light emitting element. The two bonding pads 111 for the light emitting element IC is formed in a space formed by the notch 134 on the insulator layer 102-2. Moreover, two wires (not shown) drawn from the light receiving element 105 are connected to two bonding pads 112 for the light receiving element. The two bonding pads 112 for the light receiving element are respectively connected to two bonding pads 113 for the light receiving element IC via two bonding wires 109 for the light receiving element. The two bonding pads 113 for the light receiving element IC are connected to any of the terminals 136 of the light receiving element IC 106 via the wiring pattern 120 for the light receiving element. For example, the light emitting element 104 (light receiving element 105) may be connected to FCB (flip-chip bonding) pads formed on the optical waveguide substrate 103 and may be connected to the bonding pads 110 for the light emitting element (the bonding pads 112 for the light receiving element) via a wiring pattern on the surface layer or the inner layer of the optical waveguide substrate 103.

According to the optical module 100, the optical waveguide substrate has the two inclined reflecting surfaces 124 and 126 disposed at different distances from the light input/output face 133, so that the light emitting element 104 and the light receiving element 105 can be separated from each other without increasing the width. Thus it is possible to suppress optical crosstalk (caused by stray light). Moreover, between the wiring pattern 121 for the light emitting element and the wiring pattern 120 for the light receiving element, a distance can be obtained also by forming the wiring patterns on different layers of the insulator layers 120-1 to 120-4. Thus it is also possible to suppress electromagnetic crosstalk. Furthermore, since additional structure such as a shield is not necessary, the width can be reduced (a width perpendicular to the direction of travel of light) at low cost.

In this configuration, the wiring pattern 120 for the light receiving element is quite shorter than the wiring pattern 121 for the light emitting element. Since the level of a transmitted signal is several hundreds to several thousands times higher than the level of a received signal, the received signal at the lower level is more susceptible to crosstalk. In the case of the optical module 100, the wiring pattern 120 for the light receiving element is extremely short, so that crosstalk can be further suppressed and high frequency characteristics can be improved.

### [Modification]

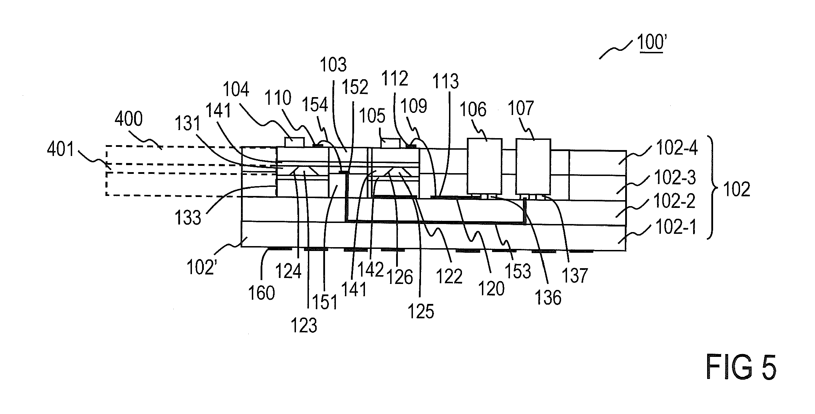

Fig. 5 is an A-A sectional view showing an optical module of a modification. A plug body 102' of an optical module 100' of the present modification also has an insulator part 151 at the position of a notch 134. Further, the optical module 100' has bonding pads 152 provided for a light emitting element IC so as to be formed on the insulator part 151, a wiring pattern 153 provided for a light emitting element to connect the bonding pads 152 for the light emitting element IC and terminals 137 of a light emitting element IC 107, and bonding wires 154 provided for the light emitting element to connect the bonding pads 152 for the light emitting element IC and bonding pads 110 for the light emitting element. The optical module 100' is different from the optical module 100 in that the insulator part 151 is provided, and the bonding pads 152 for the light emitting element IC, the wiring pattern 153 for the light emitting element, and the bonding wires 154 for the light emitting element are different from those of the optical module 100. Other configurations are similar to those of the optical module 100.

The optical module 100' has the same effect as in the first embodiment. Further, since the insulator part 151 and the notch 134 fit to each other, the optical module 100' also has the effect of positioning an optical waveguide substrate 103 and the effect of preventing the optical waveguide substrate 103 from being detached.

### [Second Embodiment]

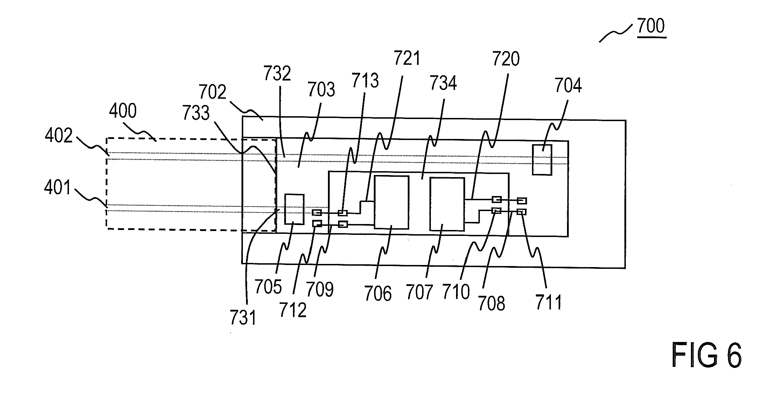

Fig. 6 is a plan view showing a structural example of an optical module except for a plug cover according to a second embodiment. An optical module 700 includes an optical waveguide substrate 703, a light emitting element 704, a light receiving element 705, a light emitting element IC 707, a light receiving element IC 706, a plug body 702, and the plug cover (not shown). The optical module 700 is different from the optical fiber module 100 in the layout of components. To be specific, in the optical fiber module 100, the light emitting element 104, the light receiving element 105, the light receiving element IC 106, and the light emitting element IC 107 are sequentially arranged from the light input/output face 133 of the optical waveguide substrate 103, whereas in the optical module 700, the light receiving element 705, the light receiving element IC 706, the light emitting element IC 707, and the light emitting element 704 are sequentially arranged from a light input/output face 733 of the optical waveguide substrate 703. In this configuration, the optical waveguide substrate 703 is larger than the optical waveguide substrate 103 and a notch 734 is also larger than the notch 134. However, the components of the optical module 700 are similar to the components of the optical fiber module 100 except for a change made by a difference in layout.

Like the optical waveguide substrate 103, the optical waveguide substrate 703 has the light input/output face 733 and two inclined reflecting surfaces (not shown) disposed at different distances from the light input/output face 733. The light emitting element 704 is disposed at a position corresponding to the inclined reflecting surface (not shown) on the optical waveguide substrate 703. The light receiving element 705 is disposed at a position corresponding to the inclined reflecting surface (not shown) on the optical waveguide substrate 703. The light emitting element 704 and the light receiving element 705 are optically coupled to the optical waveguide substrate 703 through the inclined reflecting surfaces. The light emitting element IC 707 controls the light emitting element 704. The light receiving element IC 706 controls the light receiving element 705. The plug body 702 is formed by a plurality of insulator layers and has, on the different insulator layers, a wiring pattern for the light emitting element between the light emitting element and the light emitting element IC and a wiring pattern for the light receiving element between the light receiving element and the light receiving element IC.

The optical waveguide substrate 703 is opposed to an optical waveguide 400 on the light input/output face 733. A core 401 of the optical waveguide 400 and a core 731 of the optical waveguide substrate 703 are optically connected to each other. Further, a core 402 of the optical waveguide 400 and a core 732 of the optical waveguide substrate 703 are optically connected to each other.

Two wires (not shown) drawn from the light emitting element 704 are connected to two bonding pads 711 for the light emitting element. The two bonding pads 711 for the light emitting element are respectively connected to two bonding pads 710 for the light emitting element IC via two bonding wires 708 for the light emitting element. The two bonding pads 710 for the light emitting element IC are respectively connected to the light emitting element IC 707 via a wiring pattern 720 for the light emitting element. Two wires (not shown) drawn from the light receiving element 705 are connected to two bonding pads 712 for the light receiving element. The two bonding pads 712 for the light receiving element are respectively connected to two bonding pads 713 for the light receiving element IC via two bonding wires 709 for the light receiving element. The two bonding pads 713 for the light receiving element IC are respectively connected to the light receiving element IC 706 via a wiring pattern 721 for the light receiving element. For example, the light emitting element 704 (light receiving element 705) may be connected to FCB (flip-chip bonding) pads formed on the optical waveguide substrate 703 and may be connected to the bonding pads 711 for the light emitting element (the bonding pads 712 for the light receiving element) via a wiring pattern on the surface layer or the inner layer of the optical waveguide substrate 703.

According to the optical module 700, the optical waveguide substrate 703 has the two inclined reflecting surfaces disposed at different distances from the light input/output face 733 and the notch 734 is larger than the optical module 100, so that the light emitting element 704 and the light receiving element 705 can be separated farther from each other than in the first embodiment without increasing the width. Thus it is possible to suppress optical crosstalk (caused by stray light). Moreover, the wiring pattern for the light emitting element and the wiring pattern for the light receiving element can be formed away from each other, so that the wiring patterns can be further spaced from each other as compared with the case where the wiring patterns are formed on different layers of an insulator layer. Thus it is also possible to suppress electromagnetic crosstalk. Further, since additional structure such as a shield is not necessary, the width can be reduced (a width perpendicular to the direction of travel of light) at low cost. Moreover, the wiring pattern for the light receiving element can be shortened, thereby improving high frequency characteristics.

### [Prototype result]

A prototype was produced to confirm whether an optical module can be manufactured so as to pass through a hole having a diameter of 3 mm. By setting the thickness of a plug body at 0.4 mm to 0.5 mm (each layer had a thickness of about 0.1 mm) and selecting a light emitting element and a light receiving element which were 0.1 mm to 0.2 mm in thickness, the optical module could have a thickness of 0.8 mm. Further, by setting the width of the plug body at 2.6 mm to 2.7 mm and selecting a light emitting element and a light receiving element which were about 0.3 mm in width, a diagonal line of the optical module could have a length of 2.7 mm to 2.8 mm in cross section (a cross section perpendicular to the direction of travel of light). Thus it was confirmed that an optical module can be manufactured so as to pass through a hole having a diameter of 3 mm. Thus an optical fiber can be used instead of a plurality of thin coaxial cables. Further, the optical module is about 0.8 mm in thickness and thus can be also used for thin cellular phones.

In other words, an optical code having the optical module of the present invention facilitates wiring even in a small space in small electronic equipment, and the optical code can be used as a signal line capable of suppressing crosstalk with excellent high frequency characteristics.

## Claims

1. An optical module comprising:
an optical waveguide substrate having two optical waveguides arranged in parallel, a light input/output face formed on one end of each the optical waveguides, and inclined reflecting surfaces formed for each of the optical waveguides and at a predetermined distance from each other;
a light emitting element disposed on the optical waveguide substrate at a position corresponding to one of the inclined reflecting surfaces;
a light receiving element disposed on the optical waveguide substrate at a position corresponding to the other inclined reflecting surface;
a light emitting element IC for controlling the light emitting element;
a light receiving element IC for controlling the light receiving element; and
a plug body formed by a plurality of insulator layers and having, on the different insulator layers, a wiring pattern for the light emitting element between the light emitting element and the light emitting element IC and a wiring pattern for the light receiving element between the light receiving element and the light receiving element IC, the optical waveguide substrate being formed on the plug body.

2. The optical module according to claim 1, **characterized in that** the wiring pattern for the light receiving element is not longer than the wiring pattern for the light emitting element.

3. The optical module according to claim 1, **characterized in that** the light emitting element, the light receiving element, the light receiving element IC, and the light emitting element IC are sequentially arranged from the light input/output face of the optical waveguide substrate.

4. The optical module according to claim 1, **characterized in that** the light receiving element, the light receiving element IC, the light emitting element IC, and the light emitting element are sequentially arranged from the light input/output face of the optical waveguide substrate.

5. The optical module according to any one of claims 1 to 4, **characterized in that** the optical waveguide substrate has a notch or a hole for wiring.

6. The optical module according to any one of claims 1 to 5, **characterized in that** the insulator layer is made of ceramic.

7. A photoelectric converter comprising:
the optical module further including electric contacts according to any one of claims 1 to 6; and
a receptacle having contacts making electrical contact with the electric contacts.
